# EUROPÄISCHE PATENTSCHRIFT

(11) **EP 0 473 949 B1**
(45) Veröffentlichungstag und Bekanntmachung des Hinweises auf die Patenterteilung: **21.06.1995**
(21) Anmeldenummer: 91113125.8
(22) Anmeldetag: 05.08.1991
(51) Int. Cl.: G01R 27/30, G01R 27/28, G01R 23/18

(54) **Analysator, insbesondere Netzwerkanalysator, zum frequenzselektiven Messen und Darstellen von frequenzabhängigen Messparametern**
Analysator, especially network analysator for the frequency selective measurement and display of frequency dependant measuring parameters
Analyseur, notamment analyseur de réseau, pour la représentation et la mesure selon la fréquence de paramètres de mesure variant avec la fréquence

(30) Priorität: 04.09.1990 DE 4027956
(43) Veröffentlichungstag der Anmeldung: 11.03.1992
(73) Patentinhaber: Rohde & Schwarz GmbH & Co. KG, D-81671 München (DE)
(72) Erfinder: Danzeisen, Klaus, Dipl.-Ing., W-8032 Gräfelfing (DE)
(74) Vertreter: Graf, Walter, Dipl.-Ing.

(56) Entgegenhaltungen:
- EP-A- 0 141 255
- EP-A- 0 439 157
- DE-B- 1 295 078
- DE-B- 2 553 705
- TOUTE L'ELECTRONIQUE. Nr. 530, Januar 1988, PARIS FR Seiten 64 - 71; M.ROUSSEL: 'NOUVELLES APPLICATIONS EN ANALYSE DE RESEAU VECTORIELLE'
- MICROWAVE JOURNAL. Bd. 27, Nr. 12, Dezember 1984, DEDHAM US Seiten 137 - 140;K.R. KACHIGAN: 'NEW, LARGE-SCREEEN SCALAR NETWORK ANALYZER WITH EXPANDEDCAPABILITIES'

## Beschreibung

Die Erfindung betrifft einen Analysator laut Oberbegriff des Hauptanspruchs.

In der Hochfrequenzmeßtechnik finden immer mehr Analysatoren Anwendung, die eine frequenzabhängige selektive Analyse frequenzabhängiger Meßparameter innerhalb eines interessierenden Gesamtfrequenzbereiches ermöglichen. So sind beispielsweise Spektrumanalysatoren bekannt, die es ermöglichen, die Amplitude eines Meßsignals als Funktion der Frequenz in einem breiten Gesamtfrequenzbereich in Echtzeit auf dem Schirmbild einer Kathodenstrahlröhre darzustellen (z.B. Spektrumanalysator FSA der Firma Rohde & Schwarz). Es sind auch schon sogenannte Netzwerkanalysatoren bekannt, die neben dem eigentlichen frequenzselektiven Analysator einen synchron damit abstimmbaren Mitlaufgenerator aufweisen (z.B. skalarer Netzwerk-Analysator FSAS der Firma Rohde & Schwarz). Mit solchen Netzwerk-Analysatoren kann beispielsweise der Pegelverlauf eines Vierpols in Abhängigkeit von der Frequenz gemessen werden. Es sind auch schon sogenannte komplexe Netzwerk-Analysatoren bekannt, die neben einer Einrichtung zum Messen des Pegels eine Einrichtung zur Messung der Phasen der Meßsignale aufweisen, die also sowohl eine Betrags- als auch Phasenmessung ermöglichen. Aus Betrag und Phase kann dann beispielsweise der Blindwiderstand eines Meßobjektes berechnet werden, aus der Frequenz- und Phasenänderung kann beispielsweise die Gruppenlaufzeit bestimmt werden. Mit solchen Netzwerk-Analysatoren können also die verschiedenartigsten Meßparameter eines Meßobjektes bestimmt werden.

Allen diesen bekannten Analysatoren ist der Nachteil gemeinsam, daß sie in Bezug auf Genauigkeit und Schnelligkeit der Messung nicht optimal an die jeweilige Meßaufgabe bzw. das jeweilige Meßobjekt angepaßt sind. So ist beispielsweise beim Messen eines Bandpaßfilters mit einem Netzwerkanalysator der oben beschriebenen Art im Durchlaßbereich des Filters eine hohe Pegelauflösung mit nur einigen dB Darstellbereich bei gleichzeitiger hoher Frequenzauflösung wünschenswert, während im Bereich der ansteigenden und abfallenden Flanke des Filters und im anschließenden Sperrbereich eine niedrigere Pegelauflösung gewollt ist und eine niedrigere Frequenzauflösung noch akzeptabel ist. Ähnliches gilt für andere oben erwähnte Meßparameter, die vom Benutzer ebenfalls für bestimmte Meßaufgaben möglichst frei wählbar sein sollen.

Bei den früher üblichen Wobbel-Meßgeräten zum Darstellen beispielsweise der Übertragungseigenschaften von Vierpolen als Funktion der Frequenz ist es bekannt, den insgesamt vom Wobbel-Generator zu überstreichenden Gesamtfrequenzbereich in mehrere unabhängig voneinander wählbare Teilbereiche zu unterteilen und in jedem dieser Teilbereiche einen von den anderen Teilbereichen unabhängigen Wobbelhub vorzusehen (Deutsche Patentschrift 12 95 078, aus den der Oberbegriff von Anspruch 1 abgeleitet ist, und Toute l'Electronique, Janvier 1988, No. 530, S. 64 ff., Paris). Während eines ersten den Gesamtfrequenzbereich überstreichenden Wobbelablaufs wird also beispielsweise die gesamte Durchlaßkurve eines Filters dargestellt und in einem anschließenden zweiten Wobbelablauf wird dann nur ein Teilbereich dieser Durchlaßkurve mit einer anderen Wobbelablaufgeschwindigkeit gemessen. Diese nacheinander mit unterschiedlicher Wobbelablaufgeschwindigkeit erzeugten Teilbereiche werden dann für den Betrachter gleichzeitig auf dem Bildschirm dargestellt. Mit diesem bekannten analogen Meßverfahren ist keine Echtzeitdarstellung eines interessierenden Gesamtfrequenzbereiches möglich, da die Teilbereiche nur zeitlich nacheinander gemessen werden können. Auch kann bei dieser bekannten Analogtechnik der Frequenzmaßstab in den Teilbereichen nicht beliebig gewählt werden.

Bei einem nach dem Prinzip der Fast-Fourier-Transformation arbeitenden digitalen Spektrumanalysator, bei dem das Meßobjekt mit einem speziellen Testsignal aus einem Testsignalgenerator gespeist wird, ist es bekannt, dieses in einem vorbestimmten Gesamtfrequenzbereich erzeugte Testsignal in mehrere aufeinanderfolgende und in ihrer Größe unabhängig voneinander wählbare Teilbereiche zu unterteilen und je Teilbereich die Frequenz des Testsignales jeweils an die zu messende Übertragungsfunktion des Meßobjektes anzupassen (EP-A 0 141 255). Dieses nur für niedrige Frequenzen geeignete Meßprinzip setzt die Verwendung eines Testgenerators zum Speisen des Meßobjektes voraus und ist daher nicht für Analysatoren der eingangs erwähnten Art geeignet, die nur passiv als Empfänger arbeiten.

Bei einem Hochfrequenz-Meßempfänger, der eine frequenzselektive Pegelmessung erlaubt, ist es an sich bekannt, den Gesamtfrequenzbereich in mehrere unabhängig voneinander wählbare Teilbereiche zu unterteilen (Meßempfänger ESH3 der Firma Rohde & Schwarz). Die Teilbereiche können durch Eingabe von Start-Stop-Frequenzen beliebig gewählt werden, ebenso deren Schrittweite. Allerdings kann bei diesem bekannten Meßempfänger der Frequenzmaßstab nur in allen Teilbereichen gleichartig gewählt werden, also beispielsweise in allen Teilbereichen linear oder in allen Teilbereichen logarithmisch. Auch der Amplitudenmaßstab des Pegels kann nur in allen Teilbereichen gleich groß gewählt werden.

Es ist Aufgabe der Erfindung, einen Analysator der eingangs erwähnten Art zu schaffen, der optimal an die jeweilige Meßaufgabe anpaßbar ist.

Diese Aufgabe wird ausgehend von einem Analysator laut Oberbegriff des Hauptanspruches durch dessen kennzeichnende Merkmale gelöst. Vorteilhafte Weiterbildungen insbesondere für die Ausbildung eines Netzwerk-Analysators ergeben sich aus den Unteransprüchen.

Gemäß der Erfindung kann der Frequenzmaßstab (Anzahl und frequenzmäßige Verteilung der Frequenzschritte)als auch der Meßparameter-Maßstab (z.B. Amplitudenmaßstab, Phasenmaßstab, Blindwiderstandsmaßstab, Gruppenlaufzeitmaßstab und dgl.) in unterschiedlichen Teilbereichen des Gesamtfrequenzbereiches optimal an die jeweils geforderte Meßaufgabe angepaßt werden, beim Messen des Pegelverlaufes eines Tief- oder Hochpasses in Abhängigkeit von der Frequenz wird also beispielsweise der Gesamtfrequenzbereich des Netzwerk-Analysators in zwei Teilbereiche (Durchlaßbereich bzw. Sperrbereich) aufgeteilt, und in diesen beiden Teilbereichen dann jeweils mit unterschiedlichem Frequenzmaßstab und unterschiedlichem Meßparameter-Maßstab gemessen. Zum Messen eines Bandpasses bzw. einer Bandsperre erfolgt vorzugsweise eine Aufteilung des Gesamtfrequenzbereiches in drei aneinander anschließende Teilbereiche, wobei der mittlere Teilbereich wiederum jeweils angepaßt an den Durchlaß- bzw. Sperrbereich des Filters größere Frequenz- und Pegelauflösung besitzt als in den benachbarten Sperrbereichen. Da beim erfindungsgemäßen Analysator die Anzahl der Frequenzschritte pro Teilbereich beliebig wählbar ist, kann der Analysator auch optimal an die jeweils gewünschte Meßgeschwindigkeit angepaßt werden, was beispielsweise zum Abgleich von Meßobjekten wie Bandfilter oder dgl. sehr vorteilhaft ist. Durch die gleichzeitige Einblendung von Frequenz- oder Meßparameter-Markierungen wie Pegelmarkierungen bzw. durch gleichzeitige Einblendung von Meßparameter-Toleranzlinien wie Pegel-Soll-Linien ist ein erfindungsgemäßer Analysator sehr universell für die verschiedenartigsten Meßaufgaben einsetzbar, beispielsweise zum Messen des Selektionsverlaufes von Hoch-, Tief- bzw. Bandpässen oder Bandsperren. Ein erfindungsgemäßer Analysator ist auch zum Darstellen der unterschiedlichen Selektionsverläufe eines Mehrtor-Meßobjektes geeignet, beispielsweise einer aus einem Tiefpaß und einem Hochpaß bestehenden Weiche, wenn als Meßgerät ein entsprechender Mehrkanalanalysator benutzt wird. Der Selektionsverlauf jedes einzelnen Kanals des Mehrtor-Meßobjektes wird beispielsweise in unterschiedlichen Teilbereichen gleichzeitig am Bildschirm dargestellt, wobei wiederum jedem Kanal ein von den anderen Kanälen unabhängiger Frequenz- und Meßparameter-Maßstab zugeordnet wird und auch die Frequenz- und Meßparameter-Markierungen bzw. Toleranzlinien für jeden Kanal und damit für jede einzelne Selektionskurve unabhängig von denjenigen der anderen Selektionsverläufe gewählt wird. Auf diese Weise können auch die verschiedensten Meßaufgaben an Mehrtor-Meßobjekten durchgeführt werden.

Die Erfindung wird im folgenden anhand einer schematischen Zeichnung am Beispiel eines Netzwerk-Analysators zum Messen und Darstellen des Pegelfrequenzganges eines Bandpaßfilters näher erläutert.

Fig. 1 zeigt das Prinzipschaltbild eines erfindungsgemäßen Netzwerk-Analysators.

Fig. 2 zeigt dessen Schirmbild beim Messen eines Bandpaßfilters.

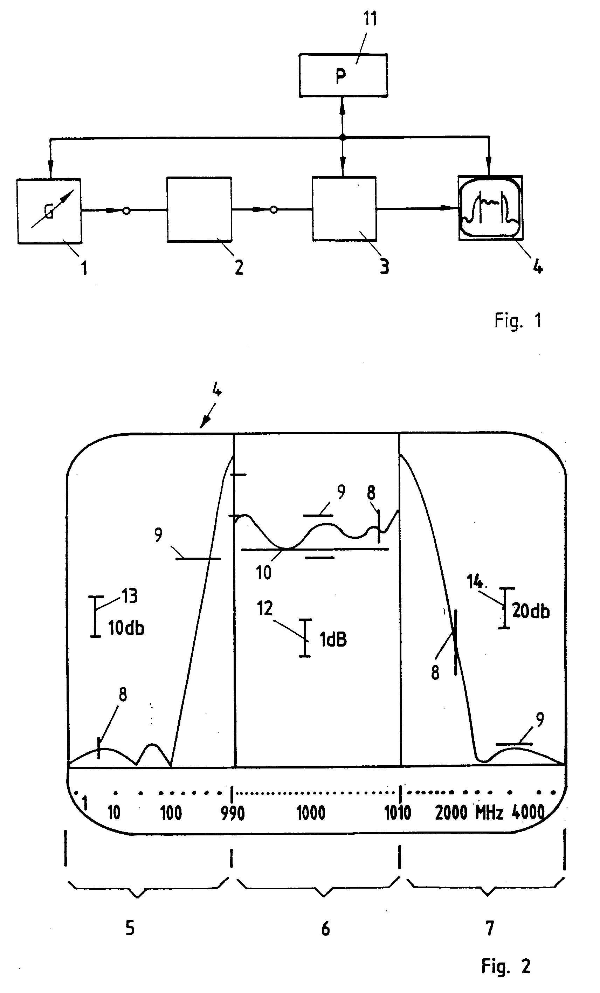

Der Netzwerk-Analysator nach Fig. 1 besteht aus einem Hochfrequenzgenerator 1 (Mitlauf- oder Tracking-Generator) zum schrittweisen Erzeugen von Meßsignalen unterschiedlicher Frequenz beispielsweise in einem Gesamtfrequenzbereich von 1 bis 4000 MHz, die in ein Meßobjekt 2 einspeisbar sind sowie einem frequenzselektiven Meßgerät 3, beispielsweise zum Messen des Pegels und/oder der Phase, oder anderer Hochfrequenz-Meßparameter am Ausgang des Meßobjektes. Das Meßergebnis wird auf dem Schirmbild einer Anzeigeeinrichtung 4 graphisch dargestellt. Der Generator 1 ist mit dem frequenzselektiven Meßgerät 3 über eine Steuereinrichtung 11 synchronisiert, diese Steuereinrichtung 11, beispielsweise ein Mikroprozessor, erzeugt im Generator 1 schrittweise die in der Frequenz unterschiedlichen Meßsignale und das Meßgerät 3 wird automatisch in gleichen Schritten in der Frequenz abgestimmt. Bei einer analogen Meßergebnisauswertung ist der Ausgang des Meßgerätes 3 unmittelbar mit der Anzeigeeinrichtung 4 verbunden, die Auswertung kann jedoch eventuell auch digital im Mikroprozessor 11 durchgeführt werden, das Anzeigeergebnis wird der Anzeigeeinrichtung 4 in diesem Fall dann über den Mikroprozessor 11 zugeführt.

Fig. 2 zeigt in Echtzeit die Darstellung des Pegelverlaufes eines Bandpaßfilters in Abhängigkeit von der Frequenz.

Zum Messen eines Bandpaßfilters wird der Gesamtfrequenzbereich von 1 bis 4000 MHz beispielsweise aufgeteilt in drei aneinander anschließende Teilbereiche 5, 6 und 7, der erste Teilbereich umfaßt beispielsweise den Sperrbereich von 1 bis 990 MHz und zwar ist hierfür ein logarithmischer Maßstab gewählt, der zweite Teilbereich 6 entspricht dem Durchlaßbereich von 990 bis 1010 MHz und hierfür ist vorzugsweise ein linearer Frequenzmaßstab gewählt, der dritte Teilbereich entspricht dem oberen Sperrbereich zwischen 1010 und 4000 MHz und besitzt wieder logarithmischen Frequenzmaßstab. Die Anzahl der Meßpunkte kann unabhängig von dem gewählten Frequenzmaßstab sein. Wenn z.B. in den Bereichen 5 und 7 mit logarithmischem Maßstab die Anzahl der Meßpunkte pro MHz konstant gewählt wird, ergibt sich eine für die Auswertung sehr günstige Verteilung der Meßpunkte, denn dadurch wird die Anzahl der Meßpunkte im Übergangsbereich von Durchlaßbereich zu Sperrbereich des Filters im Bereich 5 erhöht und so die graphische Auswertung der gemessenen Filterdurchlaßkurve wesentlich genauer. Für den unteren Sperrbereich 5 werden beispielsweise 0,1 Meßwerte pro MHz gewählt, also insgesamt etwa 99 Meßpunkte, davon aber 89 zwischen 100 und 990 MHz, im anschließenden Durchlaßbereich 6 mit linearem Frequenzmaßstab werden fünf Meßwerte pro MHz gewählt, dies ergibt rund 100 Meßpunkte in diesem Bereich 6. Im oberen Sperrbereich 7 mit logarithmischem Frequenzmaßstab wird wieder im Übergangsbereich zwischen Durchlaßbereich 6 und Sperrbereich 7 eine erhöhte Anzahl von Meßpunkten gewählt, zwischen 1010 und 2000 MHz werden beispielsweise 0,05 Meßwert pro MHz gewählt, was einer in diesem logarithmischen Bereich erhöhten Anzahl von ca. 50 Meßpunkten entspricht, im anschließenden Bereich zwischen 2000 und 4000 MHz werden dann nur 0,005 Meßwerte pro MHz gewählt, was nur noch ca. 10 Meßpunkten entspricht. Die Anzahl der Meßwerte und damit auch die Anzahl der gewonnenen Amplitudenwerte kann damit unter Berücksichtigung des gewählten Frequenzmaßstabes genau an die jeweilige Meßaufgabe angepaßt werden, in bestimmten Bereichen, in welchen eine erhöhte Frequenz- und Pegelauflösung gewünscht wird, kann die Anzahl der Meßwerte beliebig erhöht werden, so daß in diesen Bereichen genauer gemessen werden kann. Die Wahl der Anzahl der Meßpunkte pro MHz ist dabei nicht an die gewählte Darstellungsart der Frequenzachse (z.B. linear oder logarithmisch) gebunden, es kann jederzeit eine lineare Frequenzachse mit unterschiedlicher Anzahl und Verteilung von Meßpunkten pro MHz odr eine logarithmische Frequenzachse mit automatisch zunehmender Anzahl von Meßpunkten pro MHz in dem interessierenden Frequenzabschnitt gewählt werden. Die Meßpunkte werden über den Mikroprozessor 11 sowohl im Hochfrequenzgenerator 1 als auch im Meßgerät 3 in der gewünschten Anzahl und Verteilung eingestellt.

Im frequenzselektiven Meßgerät 3 ist der Maßstab der Amplitude des Meßparameters für jedes der Teilbereiche 5, 6 und 7 ebenfalls unterschiedlich gewählt und an die jeweilige Meßaufgabe angepaßt, im Teilbereich 5 und 7 entspricht eine Maßstabseinheit 13 beispielsweise 10 dB, im Durchlaßbereich 6, in dem eine hohe Pegelauflösung gewünscht wird, entspricht eine Maßstabseinheit 12 1 dB, im oberen Sperrbereich 7 ist eine Einheit 14 von 20 dB gewählt. Für den Durchlaßbereich 6 des Bandpaßfilters ist also sowohl die Anzahl und Verteilung der Meßsignale als auch der Pegelmaßstab optimal an die in diesem Teilbereich gewünschte Meßaufgabe angepaßt, der Benutzer kann am Schirmbild mit hoher Pegel- und Frequenzauflösung den Durchlaßbereich des Bandpaßfilters auswerten und eventuell korrigieren während der weniger interessierende Sperrbereich 5 bzw. 7 des Filters mit geringerer Frequenz- und Pegelauflösung dargestellt wird. Auf diese Weise kann durch entsprechende Einstellung des Hochfrequenzgenerators 1 und des Meßgerätes 3 für jedes beliebige Meßobjekt jeweils die optimale Aufteilung der Teilbereiche und der zugehörigen Maßstäbe gewählt werden. Über den Mikroprozessor 11 kann die Steuerung des Generators 1 bzw. des frequenzselektiven Meßgerätes 3 auch automatisch so erfolgen, daß beispielsweise bei linearer Darstellung eines Teilbereiches automatisch eine höhere Frequenz- und Pegelauflösung eingestellt wird während beispielsweise für eine logarithmische Darstellung automatisch eine geringere Frequenz- und Pegelauflösung eingestellt wird.

Zusätzlich kann in jedem Teilbereich auch noch eine Frequenzmarkierung 8 bzw. eine Pegelmarkierung 9 eingeblendet werden und zwar können diese Markierungen jeweils wieder völlig unabhängig von den Markierungen der anderen Teilbereiche eingestellt werden. In gleicher Weise können auch Meßparameter-Toleranzlinien eingeblendet werden, wie dies mit der Pegeltoleranzlinie 10 für den Durchlaßbereich 6 in Fig. 2 dargestellt ist.

Gemäß einer Weiterbildung der Erfindung kann im Gesamtfrequenzbereich beispielsweise auch unabhängig von der Aufteilung der einzelnen Teilbereiche 5, 6 und 7 auch ein unterschiedlicher Pegel für das Ausgangssignal des Mitlaufgenerators 1 gewählt werden, wie dies für manche Meßaufgaben sinnvoll ist. In den Bereichen 5 und 7 ist aufgrund der Selektionseigenschaften des Filters der zu messende Pegel am Ausgang des Meßobjektes 2 relativ klein und damit der Rauschabstand relativ gering. Es ist daher beispielsweise sinnvoll, ab einem bestimmten Wert des Ausgangspegels des Meßobjektes 2 den Pegel des Generators 1 automatisch etwa anzuheben, um dadurch den Rauschabstand zu verbessern, im Durchlaßbereich 6 kann der Ausgangspegel des Generators 1 dagegen geringer gewählt werden. Auf diese Weise kann also auch der Ausgangspegel des Generators 1 über dem Mikroprozessor 11 optimal an die jeweilige Meßaufgabe angepaßt werden, wobei diese Anpassung natürlich nicht an die gewählten Teilbereichsgrenzen des Meßgerätes 3 gebunden ist, sondern völlig unabhängig von diesen Teilbereichen und den dabei gewählten Frequenz- und Pegelmaßstäben beliebig gewählt werden kann.

## Patentansprüche

1. Analysator (3) zum frequenzselektiven Messen und Darstellen von frequenzabhängigen Meßparametern eines Meßsignals, der zum frequenzselektiven Empfang dieses Meßsignals innerhalb eines interessierenden Gesamtfrequenzbereiches (z.B. 1 bis 4000 MHz) in Schritten in der Frequenz abstimmbar ist und dessen dabei gemessene Meßparameter mittels einer Anzeigeeinrichtung (4) graphisch darstellbar sind und bei dem der Empfangsfrequenzbereich (z.B. 1 bis 4000 MHz) in mehrere aufeinanderfolgende, in ihrer Größe unabhängig voneinander wählbare Teilbereiche (5, 6, 7) unterteilt ist, dadurch gekennzeichnet, daß je Teilbereich (5, 6, 7) nicht nur die Anzahl sondern auch die frequenzmäßige Verteilung der Frequenzschritte unabhängig von der Anzahl und der frequenzmäßigen Verteilung der Frequenzschritte der anderen Teilbereiche und auch der Maßstab der Darstellung der Meßparameter unabhängig vom Maßstab der Darstellung der Meßparameter der anderen Teilbereiche wählbar sind, so daß während eines einzigen Durchstimmvorganges der Meßparameter in den aufeinanderfolgenden Teilbereichen mit unterschiedlicher Verteilung der Frequenzschritte meßbar und mit unterschiedlichem Meßparameter-Maßstab darstellbar ist, wobei je Teilbereich (5, 6, 7) sowohl die Anzahl und frequenzmäßige Verteilung der Frequenzschritte als auch der zugehörige Meßparameter-Maßstab auf der Anzeigeeinrichtung (4) darstellbar ist.

2. Analysator nach Anspruch 1, dadurch **gekennzeichnet**, daß über den den Analysator (3) in der Frequenz steuernden Mikroprozessor (11) der Meßparameter-Maßstab je Teilbereich automatisch an die Anzahl und frequenzmäßige Verteilung der Frequenzschritte anpaßbar ist.

3. Analysator nach Anspruch 1 oder 2, dadurch **gekennzeichnet**, daß in den einzelnen Teilbereichen voneinander unabhängige Meßparameter-Toleranzlinien (10) darstellbar sind, die unabhängig von den Toleranzlinien der anderen Teilbereiche einstellbar sind.

4. Analysator nach einem der vorhergehenden Ansprüche, dadurch **gekennzeichnet**, daß zum Messen von Mehrtor-Meßobjekten die Anzahl und frequenzmäßige Verteilung der Frequenzschritteund der Meßparameter-Maßstab für die einzelnen Tore des Meßobjektes unabhängig von denjenigen der anderen Tore wählbar ist und das Ergebnis in verschiedenen Teilbildern dargestellt wird.

5. Analysator nach Anspruch 5, dadurch **gekenn****zeichnet**, daß beim Messen von Mehrtor-Meßobjekten die Frequenz- und Meßparameter-Markierungen bzw. Toleranzlinien für die einzelnen Tore unabhängig von denjenigen der anderen Tore wählbar sind und in verschiedenen Teilbildern dargestellt werden.

6. Netzwerkanalysator mit einem Analysator nach einem der vorhergehenden Ansprüche und mit einem Mitlaufgenerator (1), der innerhalb des Empfangsfrequenzbereiches in der Frequenz und in der Amplitude einstellbar ist, dadurch **gekennzeichnet**, daß die Amplitudeneinstellung des Mitlaufgenerators (1) unabhängig von der Wahl des Meßparameter-Maßstabes und der Anzahl und frequenzmäßigen Verteilung der Frequenzschritte der Teilbereiche des Empfangsfrequenzbereiches des Analysators (3) wählbar ist.

## Claims

1. Analyser (3) for frequency-selective measurement and representation of frequency-dependent test parameters in respect of a test signal, being adapted to be frequency-tuned in increments for frequency-selective reception of said test signal within a total frequency range of interest (e.g. 1 to 4000 MHz) and the test parameters so measured being adapted to be represented graphically by means of a display device (4), and where the receive frequency range (e.g. 1 to 4000 MHz) is divided into a plurality of consecutive sub-ranges (5, 6, 7) whose size can be chosen independently of one another,
characterised in that in respect of each sub-range (5, 6, 7) not only the number but also the frequency distribution of the frequency increments can be chosen independently of the number and frequency distribution of the frequency increments of the other sub-ranges and also the scale of the representation of the test parameters can be chosen independently of the scale of the representation of the test parameters of the other sub-ranges, with the result that in the course of a single tuning operation the test parameter is measurable in the successive sub-ranges using a varying distribution of the frequency increments and is representable using a varying test parameter scale, and for each sub-range (5, 6, 7) both the number and frequency distribution of the frequency increments and also the associated test parameter scale is representable on the display device (4).

2. Analyser according to claim 1, characterised in that the test parameter scale for each sub-range can automatically be adapted to the number and frequency distribution of the frequency increments via the microprocessor (11) which controls the frequency of the analyser (3).

3. Analyser according to claim 1 or 2, characterised in that test parameter tolerance lines (10) independent of one another can be represented in the individual sub-ranges and can be set independently of the tolerance lines of the other sub-ranges.

4. Analyser according to any of the preceding claims, characterised in that to measure n-port network items under test, the number and frequency distribution of the frequency increments and the test parameter scale for the individual gates of the item under test can be chosen independently of those of the other gates and the result is represented in different segments.

5. Analyser according to claim 5, characterised in that when measuring n-port network items under test, the frequency and test parameter markers and tolerance lines for the individual gates can be chosen independently of those of the other gates and are represented in different segments.

6. Network analyser having an analyser according to any of the preceding claims, and having a tracking generator (1) which can be adjusted for frequency and amplitude within the receive frequency range, characterised in that the amplitude setting in respect of the tracking generator (1) can be chosen independently of the choice of the test parameter scale and of the number and frequency distribution of the frequency increments of the sub-ranges of the receive frequency range of the analyser (3).

## Revendications

1. Analyseur servant à la mesure et la représentation selon la fréquence de paramètres de mesure variant avec la fréquence d'un signal de mesure, qui peut être accordé en fréquence pas à pas pour la réception selon la fréquence de ce signal de mesure à l'intérieur d'une gamme complète intéressante de fréquences (allant par exemple de 1 à 4000 MHz) et dont les paramètres de mesure mesurés dans ce cas peuvent être représentés graphiquement au moyen d'un système d'affichage (4) et dans le cas duquel la zone de réception des fréquences (allant par exemple de 1 à 4000 MHz) est subdivisée en plusieurs zones partielles (5, 6, 7) consécutives, dont la grandeur peut être choisie indépendamment les unes des autres, analyseur caractérisé en ce que pour chaque zone partielle (5, 6, 7) on peut choisir non seulement le nombre mais aussi la répartition par fréquences des pas de fréquence des autres zones de fréquence et aussi l'échelle de la représentation des paramètres de mesure des autres zones partielles de telle sorte que pendant un unique processus de variation de la fréquence le paramètre de mesure peut être mesuré dans les zones partielles consécutives avec une répartition différente des pas de fréquence et peut être représenté avec une échelle des paramètres de mesure différente, dans chaque zone de fréquence partielle (5, 6, 7) aussi bien le nombre et la répartition des pas de fréquence comme aussi l'échelle correspondante des paramètres de mesure pouvant être représentés sur le système de visualisation (4).

2. Analyseur selon la revendication 1, caractérisé en ce qu'au moyen du microprocesseur (11) qui commande la fréquence de l'analyseur (3) on peut adapter l'échelle des paramètres de mesure pour chaque zone partielle de fréquences automatiquement au nombre et à la répartition des pas de fréquence.

3. Analyseur selon la revendication 1 ou 2, caractérisé en ce que dans les différentes zones partielles on peut représenter les courbes de tolérance (10) des paramètres de mesure indépendamment les unes des autres, courbes qui sont établies indépendamment des courbes de tolérance des autres zones partielles.

4. Analyseur selon l'une des revendications précédentes, caractérisé en ce que pour mesurer des objets de mesure à portes multiples on peut choisir le nombre et la répartition des pas de fréquence et l'échelle des paramètres de mesure pour les différentes portes de l'objet de mesure indépendamment de celles des autres portes et on représente le résultat sur des schémas partiels différents.

5. Analyseur selon la revendication 5, caractérisé en ce que lors de la mesure d'objets de mesure à plusieurs portes on peut choisir les repères de fréquence et de paramètres de mesure ou les courbes de tolérance pour les différentes portes indépendamment de ceux des autres portes et on les représente dans différents schémas partiels.

6. Analyseur de réseau avec un analyseur selon l'une des revendications précédentes et avec un oscillateur verrouillé (1), dont on peut régler la fréquence et l'amplitude à l'intérieur de la zone de fréquence de réception, caractérisé en ce que le réglage en amplitude de l'oscillateur verrouillé (1) peut être choisi indépendamment du choix de l'échelle des paramètres de mesure et du nombre et de la répartition des pas de fréquence des zones partielles de fréquences de réception de l'analyseur (3).
